# EUROPEAN PATENT APPLICATION

(11) **EP 2 416 370 A1**
(43) Date of publication of application: **08.02.2012**
(21) Application number: 10172224.7
(22) Date of filing: 06.08.2010
(51) Int. Cl.: H01L 31/0224, H01L 31/18

(54) **Thin film solar fabrication process, deposition method for TCO layer, and solar cell precursor layer stack**

(71) Applicant: Applied Materials, Inc., Santa Clara, CA 95054 (US)
(72) Inventor: Kress, Markus, 63165 Mühlheim (DE); Repmann, Tobias, 63755 Alzenau (DE); Severin, Daniel, 63477 Maintal (DE)
(74) Representative: Zimmermann & Partner

(57) **Abstract**

Methods and devices for manufacturing a TCO layer of a thin film solar cell over a transparent substrate are described. Thereby, a first ZnO-containing layer is puttered with a sputtering method selected from the group consisting of: DC- sputtering, MF-sputtering, pulsed-sputtering, and combinations thereof, over the substrate with a first set of deposition parameters, a second ZnO-containing layer is puttered with a sputtering method selected from the group consisting of: DC- sputtering, MF-sputtering, pulsed-sputtering, and combinations thereof, over the first ZnO-containing layer with a second set of deposition parameters, , wherein at least one of the deposition parameters of the second set of deposition parameters is different from the corresponding parameter of the first set of deposition parameters; and the second ZnO-containing layer is textured.

## Description

### BACKGROUND OF THE INVENTION

### Field of the Invention

Embodiments of the present invention generally relate to depositing TCO layers and texturing TCO layers, which are deposited on a conditioned substrate, particularly for a front contact surface of solar cells. Specifically, they relate to a layer stack for a thin film solar cell and a method of manufacturing a TCO layer of a thin film solar cell.

### Description of the Related Art

Crystalline silicon solar cells and thin film solar cells are two types of solar cells. Crystalline silicon solar cells typically use either mono-crystalline substrates (i.e., single-crystal substrates of pure silicon) or multi-crystalline silicon substrates (i.e., poly-crystalline or polysilicon). Additional film layers are deposited onto the silicon substrates to improve light capture, form the electrical circuits, and protect the devices. Thin-film solar cells use thin layers of materials deposited on suitable substrates to form one or more p-n junctions. Suitable substrates include glass, metal, and polymer substrates.

To expand the economic uses of solar cells, efficiency must be improved. Solar cell stabilized efficiency relates to the proportion of incident radiation converted into usable electricity. For solar cells to be useful for more applications, solar cell efficiency must be improved beyond the current best performance of approximately 10% for Si based Thin Film solar modules. With energy costs rising, there is a need for improved thin-film solar cells and methods and apparatuses for forming the same in a factory environment.

In order to improve the efficiency of a solar cell, light trapping is one aspect that can be improved. In order to improve trapping of the photons, surface texture at the light entering surface can be utilized.

Another aspect for improving mass production of solar cells is the use of large scale processes and the reliability at which processes can be conducted. Thus, there is a desire to improve the processes for increasing the efficiency on a large scale and to improve applications during industrial manufacturing.

### SUMMARY OF THE INVENTION

In light of the above, a layer stack for a thin film solar cell according to independent claim 1 and a method of manufacturing a TCO layer of a thin film solar cell according to independent claim 9 are provided.

Embodiments of the invention provide methods of depositing TCO layers and texturing TCO layers, which are deposited over a conditioned surface. According to one embodiment, a layer stack for a thin-film solar cell is provided. The layer stack for a thin-film solar cell includes a transparent substrate, and a transparent conductive oxide layer deposited over the substrate. The transparent conductive oxide layer includes a first sputtered ZnO-containing layer, which is sputtered with a sputtering method selected from the group consisting of: DC-sputtering, MF-sputtering, pulsed-sputtering, and combinations thereof and a second sputtered ZnO-containing layer, which is sputtered with a sputtering method selected from the group consisting of: DC-sputtering, MF-sputtering, pulsed-sputtering, and combinations thereof, and which is deposited over the first DC-sputtered ZnO-containing layer and having at least one layer property different from the first ZnO layer. Thereby, the transparent conductive oxide layer is a textured layer.

According to another embodiment, a method of manufacturing a TCO layer of a thin film solar cell over a transparent substrate. The method includes sputtering a first ZnO-containing layer with a sputtering method selected from the group consisting of: DC- sputtering, MF-sputtering, pulsed-sputtering, and combinations thereof, over the substrate with a first set of deposition parameters, sputtering a second ZnO-containing layer with a sputtering method selected from the group consisting of: DC-sputtering, MF-sputtering, pulsed-sputtering, and combinations thereof, over the first ZnO-containing layer with a second set of deposition parameters, , wherein at least one of the deposition parameters of the second set of deposition parameters is different from the corresponding parameter of the first set of deposition parameters; and texturing the second ZnO-containing layer.

### BRIEF DESCRIPTION OF THE DRAWINGS

So that the manner in which the above recited features of the present invention are attained and can be understood in detail, a more particular description of the invention, briefly summarized above, may be had by reference to the embodiments thereof, which are illustrated in the appended drawings.

Figure 1 is a schematic side-view of a tandem junction thin-film solar cell according to one embodiment of the invention;

Figure 2 is a schematic side-view of a single junction thin-film solar cell according to another embodiment of the invention;

Figures 3A and 3B are schematic side-views of a front surface of a semiconductor precursor illustrating light trapping, which can for example be utilized for a solar cell.

Figures 4A to 4E illustrate the layers deposited on a substrate according to embodiments described herein;

Figure 5 is a schematic flow chart of a method of depositing a TCO on a substrate according to embodiments described herein; and

Figures 6A to 6F illustrate the layers deposited on a substrate according to further embodiments described herein;

Figure 7 is a schematic flow chart of a further method of depositing a TCO on a substrate according to embodiments described herein; and

Figure 8 is a schematic side view illustrating an apparatus for depositing a layer stack according to embodiments described herein and for conducting a method according to embodiments described herein.

To facilitate understanding, identical reference numerals have been used, where possible, to designate identical or similar elements that are common to the figures. It is contemplated that elements and features of one embodiment may be beneficially incorporated in other embodiments without further recitation.

It is to be noted, however, that the appended drawings illustrate only exemplary embodiments of this invention and are therefore not to be considered limiting of its scope, for the invention may admit to other equally effective embodiments.

### DETAILED DESCRIPTION

Reference will now be made in detail to the various embodiments of the invention, one or more examples of which are illustrated in the figures. Each example is provided by way of explanation of the invention and is not meant as a limitation of the invention. For example, features illustrated or described as part of one embodiment can be used on or in conjunction with other embodiments to yield yet a further embodiment. It is intended that the present invention includes such modifications and variations.

The term "substrate" as used herein shall embrace both inflexible substrates, e.g., a wafer or a glass plate, and flexible substrates such as webs and foils.

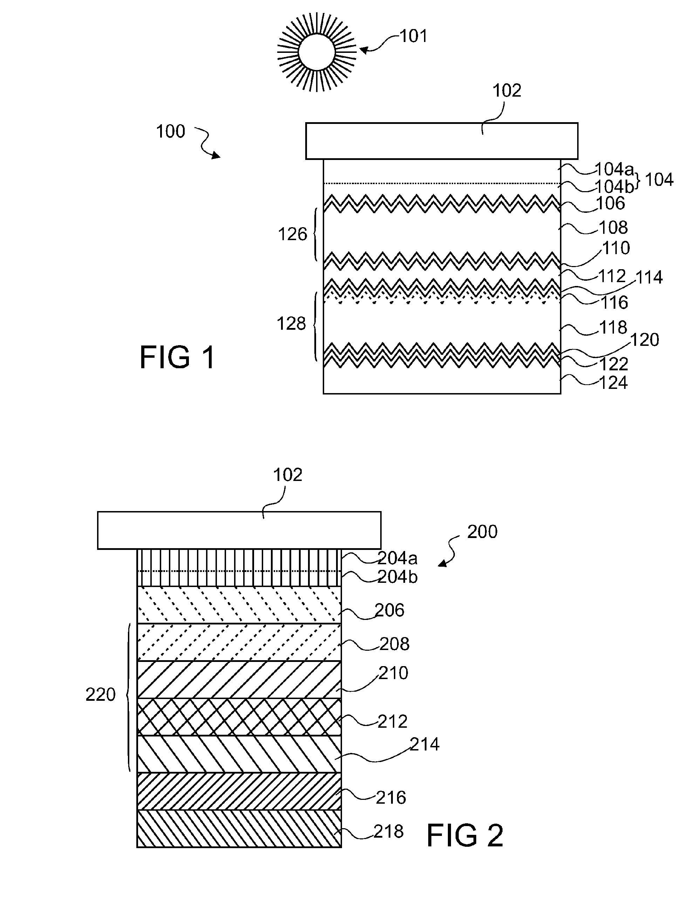

Embodiments described herein relate to processes for the etching of substrate precursors, a method of forming solar cells including etching of substrate precursors, devices for etching substrate precursors, and layer stacks for solar cells being based on substrate precursors with etching processes as described herein. Thereby, reference is for example made to the solar cells as described below and explained in further detail with respect to Figs. 1 and 2.

Thin-film solar cells are generally formed from numerous types of films, or layers, combined in many different ways. Most films used in such devices incorporate a semiconductor element that may include silicon, germanium, carbon, boron, phosphorous, nitrogen, oxygen, hydrogen and the like. Characteristics of the different films include degree of crystallinity, dopant type, dopant concentration, film refractive index, film extinction coefficient, film transparency, film absorption, and conductivity. Typically, most of these films can be formed by use of a chemical vapor deposition process, which may include some degree of ionization, plasma formation and/or sputtering processes.

Sputtering is a process in which atoms are ejected from a solid target material due to bombardment of the target by energetic particles. The process of coating a substrate as a material at the scraping refers typically to thin film applications. The term "coating" and the term "depositing" are used synonymously herein. The terms "sputtering installation" and "deposition apparatus" are used synonymously herein and shall embrace for example an apparatus which uses sputtering for depositing a target material, typically as a thin film, on a substrate. Typical target materials include (but are not limited to) pure metals such as aluminum (Al), copper (Cu), silver (Ag) and gold (Au), metal alloys such as an aluminum-niobium (AlNb) alloy or an aluminum-nickel (AlNi) alloy, semiconductor materials such as silicon (Si) and dielectric materials such as nitrides, carbides, titanates, silicates, aluminates and oxides, e.g., transparent conducting oxides (TCO) such as impurity-doped ZnO, In₂O₃, SnO₂ and CdO, as well as Sn doped In₂O₃ (ITO) and F doped SnO₂.

According to different embodiments, a plurality of films can be used in solar cells. Charge generation during a photovoltaic process is generally provided by a bulk semiconductor layer, such as a silicon-containing layer. The bulk layer is also sometimes called an intrinsic layer to distinguish it from the various doped layers present in the solar cell. The intrinsic layer may have any desired degree of crystallinity, which will influence its light-absorbing characteristics. For example, an amorphous intrinsic layer, such as amorphous silicon, will generally absorb light at different wavelengths from intrinsic layers having different degrees of crystallinity, such as microcrystalline silicon. For this reason, most solar cells will use both types of layers to yield the broadest possible absorption characteristics. In some instances, an intrinsic layer may be used as a buffer layer between two dissimilar layer types to provide a smoother transition in optical or electrical properties between the two layers.

Silicon and other semiconductors can be formed into solids having varying degrees of crystallinity. Solids having essentially no crystallinity are amorphous, and silicon with negligible crystallinity is referred to as amorphous silicon. Completely crystalline silicon is referred to as crystalline, polycrystalline, or monocrystalline silicon. Polycrystalline silicon is crystalline silicon formed into numerous crystal grains separated by grain boundaries. Monocrystalline silicon is a single crystal of silicon. Solids having partial crystallinity, that is a crystal fraction between about 5% and about 95%, are referred to as nanocrystalline or microcrystalline, generally referring to the size of crystal grains suspended in an amorphous phase. Solids having larger crystal grains are referred to as microcrystalline, whereas those with smaller crystal grains are nanocrystalline. It should be noted that the term "crystalline silicon" may refer to any form of silicon having a crystal phase, including microcrystalline and nanocrystalline silicon.

FIG. 1 is a schematic diagram of an embodiment of a multi-junction solar cell 100 oriented toward the light or solar radiation 101. Solar cell 100 includes a substrate 102, such as a glass substrate, a polymer substrate, or another suitable substrate, with thin films formed thereover. The solar cell 100 further includes a first transparent conducting oxide (TCO) layer 104 formed over the substrate 102, and a first p-i-n junction 126 formed over the first TCO layer 104. In one configuration, a wavelength-selective reflector (WSR) layer 112 is formed over the first p-i-n junction 126. A second p-i-n junction 128 is formed over the first p-i-n junction 126, a second TCO layer 122 is formed over the second p-i-n junction 128, and a metal back layer 124 is formed over the second TCO layer 122. In one embodiment, a WSR layer 112 is disposed between the first p-i-n junction 126 and the second p-i-n junction 128, and is configured to have film properties that improve light scattering and current generation in the formed solar cell 100. Additionally, the WSR layer 112 also provides a good p-n tunnel junction that has a high electrical conductivity and a tailored bandgap range that affects its transmissive and reflective properties to improve the formed solar cell's light conversion efficiency.

To improve light absorption by enhancing light trapping, the substrate and/or one or more of the thin films formed thereover may be optionally textured by wet, plasma, ion etching, and/or mechanical processes. For example, in the embodiment shown in FIG. 1, the first TCO layer 104 is textured and the subsequent thin films deposited thereover will generally follow the topography of the surface below it.

According to some embodiments described herein, a first portion 104a of a TCO layer is deposited and a second portion 104b of a TCO layer is deposited. Thereby, the first portion and the second portion are deposited each with a set of deposition parameters, wherein at least one deposition parameter of the second portion differs from the corresponding deposition parameter of the first portion. Thereby, it is possible to provide improved electrical and optical properties as well as the desired layer structure to achieve the desired texturing of the TCO layer.

The first TCO layer 104 and the second TCO layer 122 may each include tin oxide, zinc oxide, indium tin oxide, cadmium stannate, combinations thereof, or other suitable materials. It is understood that the TCO materials may also include additional dopants and components. For example, zinc oxide may further include dopants such as aluminum, gallium, boron, and other suitable dopants. Zinc oxide preferably includes 5 atomic % or less of dopants, and more preferably includes 2.5 atomic % or less aluminum. In certain instances, the substrate 102 may be provided by the glass manufacturers with the first TCO layer 104 already provided.

According to one typical embodiment, the first p-i-n junction 126 may include a p-type amorphous silicon layer 106, an intrinsic-type amorphous silicon layer 108 formed over the p-type amorphous silicon layer 106, and an n-type microcrystalline silicon layer 110 formed over the intrinsic type amorphous silicon layer 108. In certain embodiments, the p-type amorphous silicon layer 106 may be formed to a thickness between about 60Å and about 300Å. In certain embodiments, the intrinsic type amorphous silicon layer 108 may be formed to a thickness between about 1,500Å and about 3,500Å. In certain embodiments, the n-type microcrystalline semiconductor layer 110 may be formed to a thickness between about 100Å and about 400Å.

The WSR layer 112 disposed between the first p-i-n junction 126 and the second p-i-n junction 128 is generally configured to have certain desired film properties. In this configuration the WSR layer 112 actively serves as an intermediate reflector having a desired refractive index, or ranges of refractive indexes, to reflect light received from the light incident side of the solar cell 100. The WSR layer 112 also serves as a junction layer that boosts the absorption of the short to mid wavelengths of light (e.g., 280nm to 800nm) in the first p-i-n junction 126 and improves short-circuit current, resulting in improved quantum and conversion efficiency. The WSR layer 112 further has high film transmittance for mid to long wavelengths of light (e.g., 500nm to 1100nm) to facilitate the transmission of light to the layers formed in the junction 128. Further, it is generally desirable for the WSR layer 112 to absorb as little light as possible while reflecting desirable wavelengths of light (e.g., shorter wavelengths) back to the layers in the first p-i-n junction 126 and transmitting desirable wavelengths of light (e.g., longer wavelengths) to the layers in the second p-i-n junction 128.

In one embodiment, the WSR layer 112 may include an n-type doped silicon alloy layer, such as silicon oxide (SiOₓ, SiO₂), silicon carbide (SiC), silicon oxynitride (SiON), silicon nitride (SiN), silicon carbon nitride (SiCN), silicon oxycarbide (SiOC), silicon oxycarbon nitride (SiOCN), or the like. In an exemplary embodiment, the WSR layer 112 is an n-type SiON or SiC layer.

The second p-i-n junction 128 may include a p-type microcrystalline silicon layer 114 and, in some cases, an optional p-i buffer type intrinsic amorphous silicon (PIB) layer 116 that is formed over the p-type microcrystalline silicon layer 114. Subsequently, an intrinsic type microcrystalline silicon layer 118 is formed over the p-type microcrystalline silicon layer 114, and an n-type amorphous silicon layer 120 is formed over the intrinsic type microcrystalline silicon layer 118. In certain embodiments, the p-type microcrystalline silicon layer 114 may be formed to a thickness between about 100Å and about 400Å. In certain embodiments, the p-i buffer type intrinsic amorphous silicon (PIB) layer 116 may be formed to a thickness between about 50 Å and about 500 Å. In certain embodiments, the intrinsic type microcrystalline silicon layer 118 may be formed to a thickness between about 8,000Å and about 20,000Å. In certain embodiments, the n-type amorphous silicon layer 120 may be formed to a thickness between about 100Å and about 500Å.

The metal back layer 124 or a metal back layer stack may include, but is not limited to a material selected from the group consisting of A1, Ag, Ti, Cr, Au, Cu, Pt, alloys thereof, or combinations thereof. Other processes may be performed to form the solar cell 100, such as laser scribing processes. Other films, materials, substrates, and/or packaging may be provided over the metal back layer 124 to complete the solar cell device. The formed solar cells may be interconnected to form modules, which in turn can be connected to form arrays.

Solar radiation 101 is primarily absorbed by the intrinsic layers 108, 118 of the p-i-n junctions 126, 128 and is converted to electron-hole pairs. The electric field created between the p-type layer 106, 114 and the n-type layer 110, 120 that stretches across the intrinsic layer 108, 118 causes electrons to flow toward the n-type layers 110, 120 and holes to flow toward the p-type layers 106, 114 creating a current. The first p-i-n junction 126 includes an intrinsic type amorphous silicon layer 108 and the second p-i-n junction 128 includes an intrinsic type microcrystalline silicon layer 118 since amorphous silicon and microcrystalline silicon absorb different wavelengths of solar radiation 101. Therefore, the formed solar cell 100 is more efficient, since it captures a larger portion of the solar radiation spectrum. The intrinsic layer 108, 118 of amorphous silicon and the intrinsic layer of microcrystalline silicon are stacked in such a way that solar radiation 101 first strikes the intrinsic type amorphous silicon layer 118 and is transmitted through the WSR layer 112 and then strikes the intrinsic type microcrystalline silicon layer 118 since amorphous silicon has a larger bandgap than microcrystalline silicon. Solar radiation not absorbed by the first p-i-n junction 126 continuously transmits through the WSR layer 112 and continues to the second p-i-n junction 128. According to yet further implementations, which can be combined with other embodiments described herein, one or more further p-i-n junctions can be provided.

Charge collection is generally provided by doped semiconductor layers, such as silicon layers doped with p-type or n-type dopants. P-type dopants are generally group III elements, such as boron or aluminum. N-type dopants are generally group V elements, such as phosphorus, arsenic, or antimony. In most embodiments, boron is used as the p-type dopant and phosphorus as the n-type dopant. These dopants may be added to the p-type and n-type layers 106, 110, 114, 120 described above by including boron-containing or phosphorus-containing compounds in the reaction mixture. Suitable boron and phosphorus compounds generally include substituted and unsubstituted lower borane and phosphine oligomers. Some suitable boron compounds include trimethylboron (B(CH₃)₃ or TMB), diborane (B₂H₆), boron trifluoride (BF₃), and triethylboron (B(C₂H₅)₃ or TEB). Phosphine is the most common phosphorus compound. The dopants are generally provided with carrier gases, such as hydrogen, helium, argon, and other suitable gases. If hydrogen is used as the carrier gas, it adds to the total hydrogen in the reaction mixture. Thus hydrogen ratios will include hydrogen used as a carrier gas for dopants.

FIG. 2 is a schematic side-view of a single-junction thin-film solar cell 200 according to another embodiment of the invention, which might in some instances use a light trapping improvement. The embodiment of FIG. 2 differs from that of FIG. 1 by inclusion of a p-type crystalline silicon alloy layer 206 between the p-type amorphous silicon layer 208 and the TCO layer of FIG. 1. Alternatively, the p-type crystalline silicon alloy layer 206 may be a degeneratively doped layer having p-type dopants heavily doped in the alloy layer 206. The embodiment of FIG. 2 thus includes the substrate 102 on which a conductive layer 204, such as a TCO layer similar to the first TCO layer 104 of FIG. 1, is formed.

According to some embodiments described herein, a first portion of a TCO layer or a first TCO layer 204a is deposited and a second portion of a TCO layer or a second TCO layer 204b is deposited. Thereby, the first portion and the second portion are deposited each with a set of deposition parameters, wherein at least one deposition parameter of the second portion differs from the corresponding deposition parameter of the first. Thereby, it is possible to provide improved electrical and optical properties as well as the desired layer structure for a desired texturing of the TCO layer. In light thereof, according to some embodiments, which can be combined with other embodiments described herein, the first portion or the first TCO layer and the second portion (or the second TCO layer, respectively) have at least one layer property different from each other. Thereby, according to yet further embodiments, which can be combined with other embodiments described herein, the first and second portions of the TCO layer or the first and the second TCO layer, respectively, are ZnO-containing layers, which are typically DC sputtered, e.g., from a rotatable target.

As described above, a p-type crystalline silicon alloy layer 206 is formed over the conductive layer 204. The p-type crystalline silicon alloy layer 206 has improved bandgap due to lower doping, an adjustable refractive index generally lower than that of a degeneratively doped layer, high conductivity, and resistance to oxygen attack by virtue of the included alloy components. A p-i-n junction 220 is formed over the p-type crystalline silicon alloy layer 206 by forming a p-type amorphous silicon layer 208, a PIB layer 210, an intrinsic amorphous silicon layer 212, and an n-type amorphous silicon layer 214. The solar cell 200 of FIG. 2 is completed, similarly to the foregoing embodiments, with an n-type crystalline silicon alloy layer 216, which is similar to the WSR layer 112 of FIG. 1, and a second conductive layer 218, which may be a metal or metal/TCO stack, similar to the conductive layers 122, 124 of FIG. 1.

According to different embodiments, a plurality of methods and system/apparatus configurations for texturing a semiconductor precursor can be utilized in embodiments described herein. As described above, the layers, particularly the TCO layer 104 are generally textured in order to improve light trapping and, thus, the efficiency of a solar cell. In the following, it is exemplarily referred to the etching of zinc oxide (ZnO) layers as a front contact of precursors for a solar thin film. However, the same principles can be applied to other semiconductor device manufacturing methods.

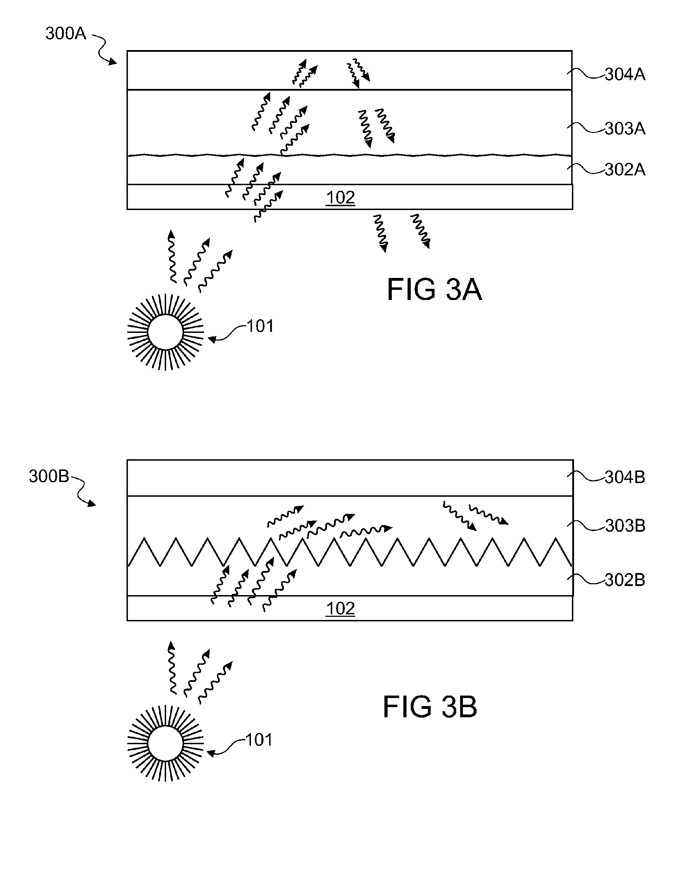

As illustrated with respect to FIGS. 3A and 3B, texturing of layers or films in the semiconductor device can, for example, improve light trapping. FIGS. 3A and 3B show the semiconductor device precursor 300A and 300B, respectively. Layers 302A, 303A, 304A and 302B, 303B, 303C, respectively, are deposited above the substrate 102. As shown in FIG. 3A, the layer 302 has a flat or almost flat upper surface. In light thereof, a portion of the radiation source 101, such as the sun for a solar cell device, can be reflected within the semiconductor device precursor. This is indicated by a portion of the photons being reflected at the upper surface of layer 304A in FIG. 3A. Thereby, the photons can leave the layer stack of a solar cell after a relative short path length. Contrary thereto, as shown in FIG. 3B, a textured surface 302B increases the likelihood of all, or at least 90 %, of the photons to enter the semiconductor device. Further, the photons are diffracted at the boundaries of the layers such that the photons might even remain in one layer by total internal reflection upon diffraction at the textured TCO layer. Thereby, the path length within the desired layer in which photons should be absorbed for light conversion is increased. This generally improves the efficiency of the layer stack for the solar cell.

According to embodiments described herein, an improved ZnO-containing TCO layer is deposited on an industrially-relevant scale. For example, the TCO layers of some embodiments described herein can be deposited on an area of 1 m² and above, 3 m² and above, 4 m² and above, or 5 m² and above. Thereby, the surface on which the ZNO-containing TCO layer is to be deposited is conditioned to provide a desired nucleation area for the desired film properties.

According to typical embodiments described herein, a ZnO layer, which is used as a TCO, is texture-etched after deposition. Thereby, a good light scattering effect (haze) should be achieved.

High-haze ZnO films, which are deposited by RF-sputter deposition, can be provided on small scales and with laboratory standards. However, the RF-technique suffers from a very low deposition rate and the difficulty to scale up the process to large areas. Generally, it is desired that the TCO layer has a high surface roughness with large lateral feature sizes in order to couple as much of the incoming sun light as possible in the Si absorber of the solar cell.

According to embodiments, which can be combined with other embodiments described herein, DC-sputtered layers, MF-(middle frequency)-sputtered layers or pulsed-sputtered layers, and the corresponding sputtering processes are used. As described herein, MF sputtering refers to middle frequency sputtering with frequencies in the range of 5 kHz to 100 kHz, for example, 10 kHz to 50 kHz, which is different from RF-sputtering processes having higher frequencies. Further, pulsed-sputtering refers to a sputtering mode, where pulses are provided on the cathode, such that for example a square wave potential is provided to the cathode. Such pulses can be added to a DC voltage or can be provided without addition of a DC voltage. Thereby, high deposition rates, e.g., such that 800 nm TCO material can be deposited within 10 min or less and easy scalability to large areas as described herein can be realized. Generally, under some circumstances, high-haze or low-resistance ZnO films can be obtained with a DC process. However, the process parameters to get high-haze ZnO can lead to films with an undesired high resistance and vice versa. In addition, the optical properties like absorption can be negatively affected by optimizing other film properties. Thus, according to the embodiments described herein, a two step or twofold process for depositing a ZnO-containing TCO layer is provided.

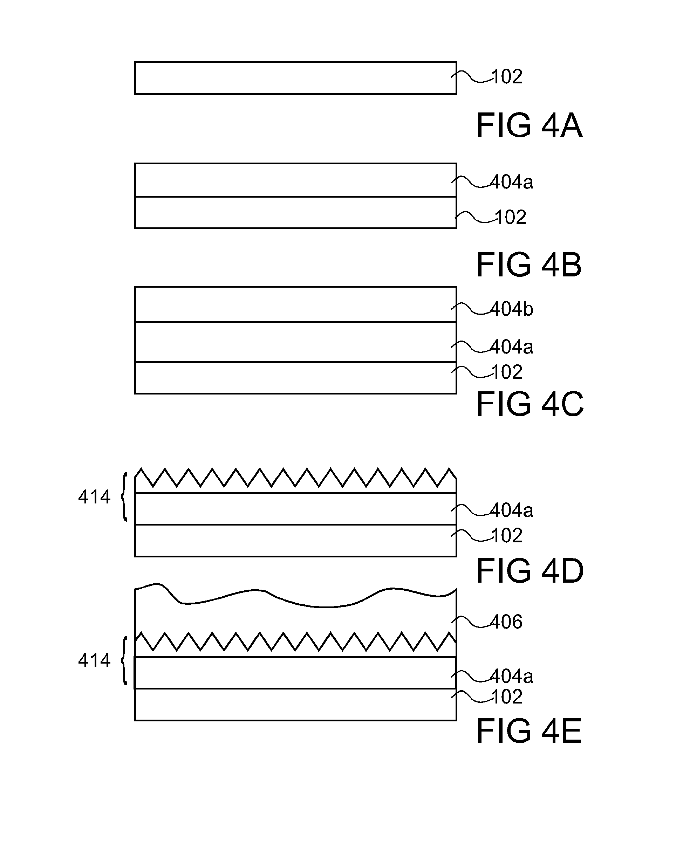

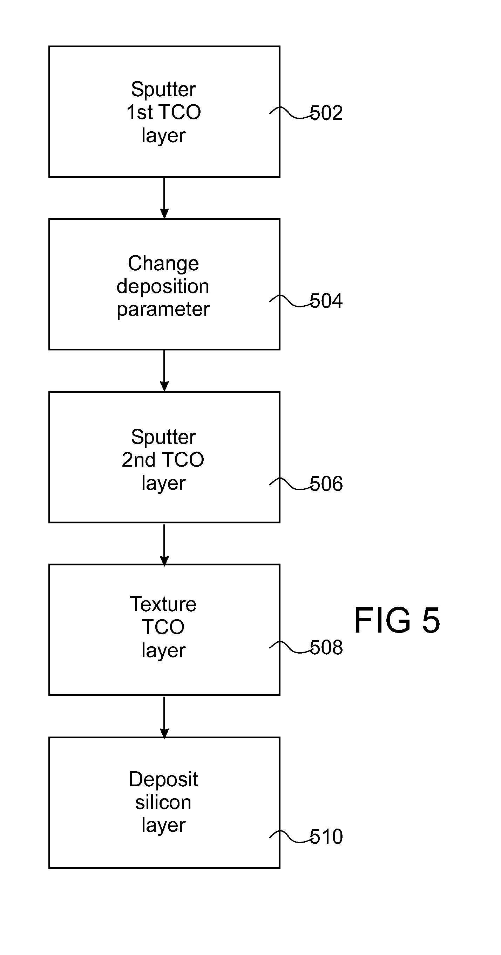

Typical embodiments are, for example, shown in FIGS. 4A to 4E, and are described in the following while referring to the method illustrated in FIG. 5. FIG. 4A shows a substrate 102 which can be provided for depositing a precursor for a solar cell and/or TCO layer. Thereby, as shown in step 502, a first portion 404a of a ZnO-containing TCO layer is deposited over the substrate 102. According to some embodiments, the TCO layer can be used as a front contact layer of a thin-film solar cell. Typically, the first portion of the TCO layer or the first ZnO-containing layer is deposited such that electrical and/or optical properties are improved, e.g., as desired for a thin film solar cell. According to embodiments described herein, the deposition process is a DC deposition process.

Thereafter, in step 504 at least one deposition parameter such as the deposition temperature, a gas flow, a deposition pressure and/or a deposition rate is changed or the substrate is moved in another deposition chamber with at least one deposition parameter such as the deposition temperature, a gas flow, a deposition pressure and/or a deposition rate being different.

In step 506, a second ZnO-containing layer 404b, is deposited on the first ZnO-containing layer 404a. This is illustrated by layer 404b shown in FIG. 4C. Typically, the second portion of the TCO layer or the second ZnO-containing layer is deposited such that the film growth is improved with regard to the texturing properties, e.g., as desired for a thin film solar cell. According to embodiments described herein, the deposition process is a DC deposition process.

As shown in FIG. 4C and step 506 of FIG. 5, a second zinc oxide layer 404b (see FIG. 4C) is deposited on the layer 404a. Thereby, according to embodiments described herein, a DC sputtered TCO layer 404, e.g., a DC-sputtered ZnO-containing layer, can be provided. Further typical embodiments relate to aluminum doped zinc oxide layers (ZnO:Al) as a TCO, which can be sputtered from rotatable ceramic zinc oxide aluminum oxide (ZnO:Al203) targets. Typically, the aluminum doped zinc oxide layers form a front contact of a solar cell.

Typically, a doped ZnO layer is deposited by DC-sputtering as a TCO front contact with a combined thickness of about 800 - 1000 nm. The doping can be, but is not restricted to, aluminum. Finally, the layer stack is etched in diluted acid in order to roughen the ZnO surface by wet etching. In step 508, the TCO layer is textured resulting in the solar cell precursor shown in FIG. 4D. In light of the above, according to some embodiments, which can be combined with other embodiments described herein, a DC-sputtered and texture etched ZnO TCO layer can be provided, wherein the transparent conductive oxide layer has a first ZnO-containing layer and a second ZnO-containing layer. Thereby, according to some additional or alternative modification, the first ZnO-containing layer 404a can have a thickness of 300 nm to 800 nm and the second ZnO-containing layer 404b can have a thickness of 100 nm to 400 nm, e.g., 200 nm to 300 nm before etching. Further, the second textured transparent conductive oxide layer can have a layer thickness of 0 nm to 200 nm, wherein the thickness of the texture surface is measured with X-ray fluorescence (XRF).

It is commonly accepted that the deposition parameters of the ZnO layer such as pressure and temperature have an impact on the surface morphology after etching and therefore on the efficiency of the solar module. Accordingly, a two-step process with varying process parameters or a two layer TCO structure with different layer characteristics is provided.

According to different embodiments, which can be combined with other embodiments described herein, at least one deposition parameter selected from the group consisting of: a deposition temperature, a gas flow, a deposition pressure; and a deposition rate can be varied for the DC sputtering processes of the first ZnO-containing layer 404a and the second ZnO-containing layer 404b. For example, the first ZnO-containing layer can be deposited at a higher temperature than the second ZnO-containing layer. Thereby, according to some embodiments, which can be combined with other embodiments described herein, the substrate temperature when entering a chamber for sputtering the first ZnO-containing layer can be in a range of 250°C to 400 °C, e.g., 300 °C to 375°C, and the substrate temperature before depositing the second ZnO-containing layer or before entering a chamber for sputtering the second ZnO-containing layer can be in a range of 100°C to 300°C. Generally, the temperatures referred to herein are temperatures on entering a deposition chamber or before depositing the ZnO-containing layers. It is to be understood that the temperatures can vary during the sputtering process itself. For example, since only a limited number of heating modules can be provided during the sputtering process the temperature may decrease during sputtering.

Thereby, according to some embodiments, which can be combined with other embodiments described herein, the deposition rate for sputtering the first ZnO-containing layer can be larger than the deposition rate for sputtering the second ZnO-containing layer. According to yet further alternative or additional modifications, the sputter atmosphere for sputtering the first ZnO-containing layer can include less N₂ than the sputtering atmosphere for sputtering the second ZnO-containing layer. For example, the sputter atmosphere for sputtering the first ZnO-containing layer can be essentially N₂-free. According to yet further embodiments, which can be combined with other embodiments described herein, the target composition can be varied for depositing the first ZnO-containing layer and the second ZnO-containing layer, such that a deposition step of the first ZnO-containing layer includes depositing first the ZnO-containing layer with a different target composition as compared to the target composition for depositing the second ZnO-containing layer. Accordingly, the dopant concentration in the first ZnO-containing layer can be different from the dopant concentration in the second ZnO-containing layer. According to yet further additional or alternative modification, the pressure in a processing region during depositing the first ZnO-containing layer can be smaller than the pressure in the processing region during depositing the second ZnO-containing layer. For example, the pressure during depositing the second ZnO-containing layer can be 1.1 to 4 times the pressure during depositing the first ZnO-containing layer. According to yet further embodiments, which can be combined with other embodiments described herein, the oxygen flow into the processing system might be varied for depositing the first and second ZnO-containing layer, respectively. According to yet other typical implementations, the oxygen flow in the processing system can be about 10% of the argon flow.

According to some embodiments, which can be combined with other embodiments described herein, the solar cell precursors, the layers stacks for solar cells and the methods and devices for manufacturing TCO layers can be utilized for large area thin films. For example, substrate sizes of 1.43 m² (Gen5) and above such as 5.7 m² (Gen8.5) or larger can be realized. Further typical embodiments relate to aluminum doped zinc oxide layers (ZnO:Al) as a TCO, which can be sputtered from rotatable ceramic zinc oxide aluminum oxide (ZnO:Al2O3) targets. Typically, the aluminum doped zinc oxide layers form a front contact of a solar cell.

According to yet further embodiments, as shown in step 508, the TCO layer can be wet-chemically etched, for example in diluted hydrochloric acid, or other suitable etchants. Thereby, a textured TCO layer 414 can be provided as shown in FIG. 4D.

Typically, the shape and feature size of the etched semiconductor layer depends on the parameters of the layer as well as the etching process. Accordingly, for a predetermined semiconductor layer with certain characteristics, the nucleation of, particularly, the second ZnO-containing layer 404b, which is the layer to be etched, needs to be controlled such that the desired texture of the layer is generated.

According to different embodiments, the texturing process can be conducted by a wet etching process or a dry etching process. According to yet further implementations, the etching process can be an isotropic or an anisotropic etching process. Typically, the texturing step 508 can be provided by etching the zinc oxide-containing TCO layer with a diluted acid in order to roughen the ZnO surface by wet etching. Thereby, as described with respect to FIGS. 3A and 3B, a specific haze is desired in order to improve light trapping of the layer stack for manufacturing a thin-film solar cell.

After texturing the TCO layer in step 508, a silicon layer 406 (see FIG. 4E) is deposited in step 510. According to typical embodiments, the silicon layer can be a p-type silicon layer, for example a p-type amorphous silicon layer 106 shown in FIG. 1. Alternatively, a p-type crystalline silicon layer 206 shown in FIG. 2 can be deposited on the textured TCO layer 414. Generally, one or more p-n-junctions are deposited on the TCO layer. Thereby, the textured TCO layer 414 forms the front contact of a precursor of a thin-film solar cell.

According to embodiments described herein the deposition process of the doped ZnO can be conducted to improve or optimize the optical, electrical, and haze properties in parallel. According to some embodiments, the layer stack design is provided by a glass substrate, a buffer layer, such as a SiON-layer, a ZnO-containing layer (step 1) and a further ZnO-containing layer (step 2). Thereby, in the first step (step 502 in FIG. 5), a fraction or portion of the ZnO-containing TCO layer is deposited on the buffer layer, wherein the resistance and the absorption should be as low as possible. In the second step (step 506 in FIG. 5), another fraction or portion of the ZnO-containing TCO layer is deposited, wherein desirable haze properties after etching are achieved. For example, high deposition temperatures as described above can lead to films with a low resistance but also low haze. Yet, a relatively low deposition temperature as described above can lead to a higher film resistance but also to a higher haze. Therefore, as one example, the first ZnO fraction can be sputtered at a higher temperature followed by a film fraction sputtered at lower temperature. By combining both steps, the entire ZnO-containing TCO film stack can reveal a low resistance from the first fraction and a high haze after etching from the second fraction.

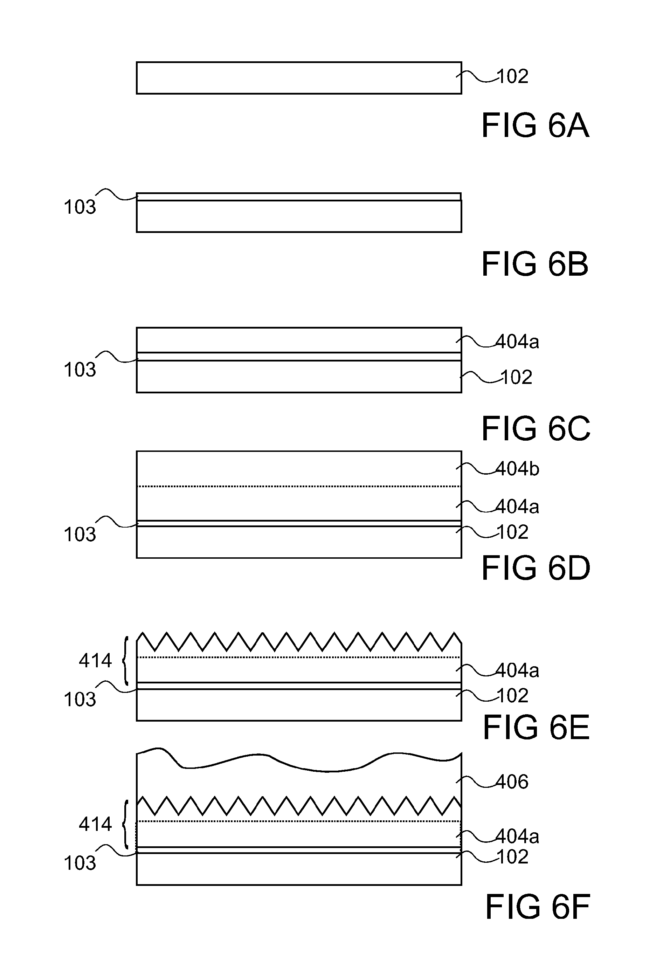

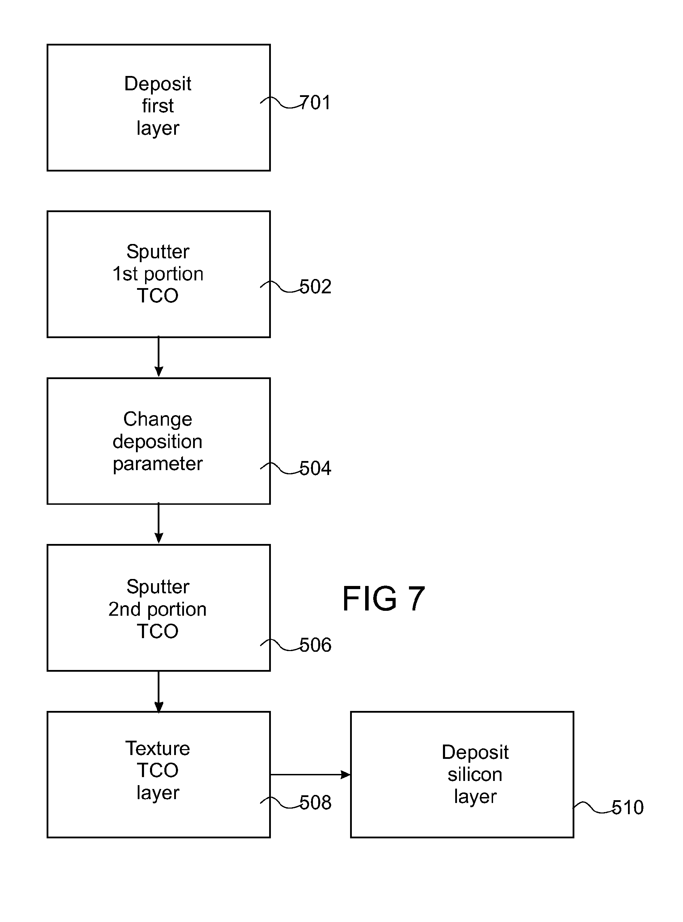

Further typical embodiments are, for example, shown in FIGS. 6A to 6F, which are described in the following while referring to the method illustrated in FIG. 7. FIG. 6A shows a substrate 102 which can be provided for depositing a precursor for a solar cell and/or a TCO layer. Thereby, as shown in step 701, a buffer layer 103 (see also FIG. 6B), such as a SiON buffer layer, is provided. Thereby, according to some additional or alternative modification, the layer 103 can have a thickness of below 100 nm, for example a thickness of 20 nm to 100 nm or of 50 to 90 nm. Typically, the buffer layer can be provided such that at least one characteristic is provided, which is selected from the group consisting of: the buffer layer has a refraction index, which is between the refraction index of the substrate and the refraction index of TCO layer, the buffer layer enables improved nucleation of the TCO layer, and the buffer layer is configured for providing a diffusion barrier for alkali-metals, which might originate from a transparent substrate, e.g., a glass substrate.

According to some embodiments, the layer can be referred to as a buffer layer. Thereby, it is indicated that a buffer for conditioning of the below surface, e.g., the surface of a substrate or the layer stack below, is provided such that an improved nucleation of the subsequent layer can be provided. According to some embodiments, which can be combined with other embodiments described herein, the layer 413 can have a refraction index which is between the refraction indexes of the two neighboring layers, e.g., the refraction index of the transparent substrate 102 below the layer 103 and the refraction index of the TCO layer 604. For example, the refraction index can be from 1.5 to 2.1

According to some embodiments, which can be combined with other embodiments described herein, the layer 103 can be a SiON layer, which is reactively sputtered from a silicon target with the addition of oxygen and nitrogen. Thereby, a certain amount of metals such as aluminum, titanium or zinc can be incorporated into the layer 103 by a mixed target composition instead of pure silicon.

According to yet further embodiments, which can be combined with other embodiments described herein, the refraction index can be adjusted as described herein. Further, a barrier function, can be provided and/or the layer can have an average absorption of below 1% or even below 0.5% in the visible wavelength range or the visible wavelength range and the NIR wavelength range, e.g., from 380 to 1300 nm.

According to a typical embodiment, which can be combined with other embodiments described herein, a silicon target with an aluminum content, for example of 2 to 10 weight-%, can be used for depositing the layer 103. Yet, according to other embodiments, also other metal additions in the silicon target such as Ti, Zn or combinations thereof might be used. According to yet further additional or alternative modifications, the metal-containing layer 413 can be a MF sputtered layer. According to yet further embodiments, which can be combined with other embodiments described herein, the middle frequency sputtering with frequencies in the range of 5 kHz to 100 kHz, for example, 20 kHz to 50 kHz, can be provided for manufacturing the solar cell layer stack.

After depositing the buffer layer 103 in step 701, a first portion 604a of a ZnO-containing TCO layer is deposited over the substrate 102. According to some embodiments, the TCO layer can be used as a front contact layer of a thin-film solar cell. Typically, the first portion of the TCO layer or the first ZnO-containing layer is deposited such that the electrical and/or optical properties are improved, e.g., as desired for a thin film solar cell. According to embodiments described herein, the deposition process is a DC deposition process.

Thereafter, in step 504 at least one deposition parameter such as the deposition temperature, a gas flow, a deposition pressure and/or a deposition rate is changed or the substrate is moved into another deposition chamber with at least one deposition parameter such as the deposition temperature, a gas flow, a deposition pressure and/or a deposition rate being different.

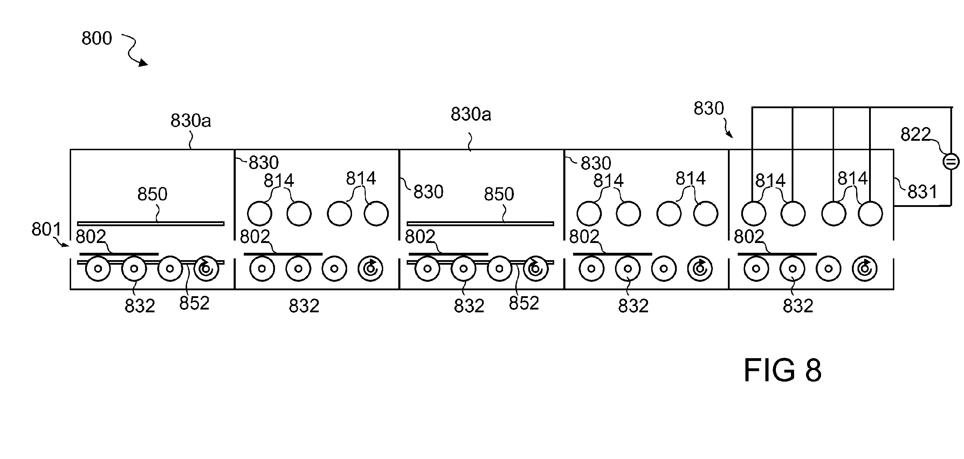

In step 506, a second portion of the ZnO-containing layer, is deposited. As indicated by the dotted line in FIGS. 6, the second portion can be deposited by continuously changing one of the sputtering parameters in the border region between the first portion of the ZnO-containing layer and the second ZnO-containing layer. However, as described above with respect to FIGS. 4 and as described with respect to FIG. 8 below, the transparent conductive oxide layer, can according to some embodiments, which can be combined with other embodiments described herein, be separate layers, which are for example deposited in separate chambers or chamber portions. Typically, the second portion of the TCO layer or the second ZnO-containing layer is deposited such that the film growth is improved with regard to the texturing properties, e.g., as desired for a thin film solar cell. According to embodiments described herein, the deposition process is a DC deposition process.

As shown in FIG. 6D and step 506 of FIG. 5, a second zinc oxide layer is deposited on the layer 604a. Thereby, according to embodiments described herein, a DC sputtered TCO layer 604, e.g., a DC-sputtered ZnO-containing layer, can be provided. Further typical embodiments relate to aluminum doped zinc oxide layers (ZnO:Al) as a TCO, which can be sputtered from rotatable ceramic zinc oxide aluminum oxide (ZnO:Al2O3) targets. Typically, the aluminum doped zinc oxide layers form a front contact of a solar cell.

Typically, a doped ZnO layer is deposited by DC-sputtering as a TCO front contact with a combined thickness of about 800 - 1000 nm. The doping can be, but is not restricted to, aluminum. Finally, the layer stack is etched in diluted acid in order to roughen the ZnO surface by wet etching. In step 508, the TCO layer is textured resulting in the solar cell precursor shown in FIG. 6E. In light of the above, according to some embodiments, which can be combined with other embodiments described herein, a DC-sputtered and texture etched ZnO TCO layer can be provided, wherein the transparent conductive oxide layer has a first ZnO-containing layer and a second ZnO-containing layer. Thereby, according to some additional or alternative modification, the first ZnO-containing layer 604a can have a thickness of 300 nm to 800 nm and the second ZnO-containing layer can have a thickness of 100 nm to 400 nm, e.g., 200 nm to 300 nm before etching.

According to different embodiments, which can be combined with other embodiments described herein, at least one deposition parameter selected from the group consisting of: a deposition temperature, a gas flow, a deposition pressure; and a deposition rate can be varied for the DC sputtering process or processes of the first ZnO-containing layer 604a and the second portion of the ZnO-containing layer. For example, the first ZnO-containing layer can be deposited at a higher temperature than the second ZnO-containing layer. Thereby, according to some embodiments, which can be combined with other embodiments described herein, the substrate temperature when entering a chamber for sputtering the first ZnO-containing layer can be 250°C to 400 °C, e.g., 300 °C to 375°C, and the substrate temperature before depositing the second ZnO-containing layer or before entering a chamber for sputtering the second ZnO-containing layer can be 100°C to 300°C. Generally, the temperatures referred to herein are temperatures upon entering a deposition chamber or before depositing the ZnO-containing layers. It is to be understood that the temperatures can vary during the sputter process itself. For example, since only a limited number of heating modules can be provided during the sputtering process, the temperature may decrease during sputtering.

Thereby, according to some embodiments, which can be combined with other embodiments described herein, the deposition rate for sputtering the first ZnO-containing layer can be larger than the deposition rate for sputtering the second ZnO-containing layer. According to yet further alternative or additional modifications, the sputter atmosphere for sputtering the first ZnO-containing layer can include less N₂ than the sputtering atmosphere for sputtering the second ZnO-containing layer. For example, the sputter atmosphere for sputtering the first ZnO-containing layer can be essentially N₂-free.. According to yet further embodiments, which can be combined with other embodiments described herein, the target composition can be varied for depositing the first ZnO-containing layer and the second ZnO-containing layer, such that a deposition step of the first ZnO-containing layer includes depositing first the ZnO-containing layer with a different target composition as compared to the target composition for depositing the second ZnO-containing layer. Accordingly, the dopant concentration in the first ZnO-containing layer can be different from the dopant concentration in the second ZnO-containing layer. According to yet further additional or alternative modification, the pressure in a processing region during depositing the first ZnO-containing layer can be smaller than the pressure in the processing region during depositing the second ZnO-containing layer. For example, the pressure during depositing the second ZnO-containing layer can be 1.1 to 4 times the pressure during depositing the first ZnO-containing layer. According to yet further embodiments, which can be combined with other embodiments described herein, the oxygen flow into the processing system might be varied for depositing the first and second ZnO-containing layer, respectively. According to yet other typical implementations, the oxygen flow in the processing system can be about 10% of the argon flow.

According to some embodiments, which can be combined with other embodiments described herein, the solar cell precursors, the layers stacks for solar cells and the methods and devices for manufacturing TCO layers can be utilized for large area thin films. For example, substrate sizes of 1.43 m² (Gen5) and above such as 5.7 m² (Gen8.5) or larger can be realized. Further typical embodiments relate to aluminum doped zinc oxide layers (ZnO:Al) as a TCO, which can be sputtered from rotatable ceramic zinc oxide aluminum oxide (ZnO:Al2O3) targets. Typically, the aluminum doped zinc oxide layers form a front contact of a solar cell.

According to yet further embodiments, as shown in step 508, the TCO layer can be wet-chemically etched, for example in diluted hydrochloric acid, or other suitable etchants. Thereby, a textured TCO layer 614 can be provided as shown in FIG. 6E.

Typically, the shape and feature size of the etched semiconductor layer depends on the parameters of the layer as well as the etching process. Accordingly, for a predetermined semiconductor layer with certain characteristics, the nucleation of particularly the second ZnO-containing layer, which is the layer to be etched, needs to be controlled, such that the desired texture of the layer is generated.

According to different embodiments, the texturing can be conducted by a wet etching process or a dry etching process. According to yet further implementations, the etching process can be an isotropic or an anisotropic etching process. Typically, the texturing step 508 can be provided by etching the zinc oxide-containing TCO layer with a diluted acid in order to roughen the ZnO surface by wet etching. Thereby, as described with respect to FIGS. 3A and 3B, a specific haze is desired in order to improve light trapping of the layer stack of a thin-film solar cell.

After texturing the TCO layer in step 508, a silicon layer 406 (see FIG. 6F) is deposited in step 510. According to typical embodiments, the silicon layer can be a p-type silicon layer, for example a p-type amorphous silicon layer 106 shown in FIG. 1. Alternatively, a p-type crystalline silicon layer 206 shown in FIG. 2 can be deposited over or onto the textured TCO layer 614. Generally, one or more p-n-junctions are deposited over the TCO layer. Thereby, the textured TCO layer 614 forms the front contact of a precursor of a thin-film solar cell.

According to embodiments described herein the deposition process of the doped ZnO can be conducted to improve or optimize the optical, electrical, and haze properties in parallel. According to some embodiments, in particular, the TCO layer stack design is includes, in this order, a glass substrate, a buffer layer, a ZnO-containing layer (step 1) and a further ZnO-containing layer (step 2). Thereby, in the first step (step 502 in FIG. 5), a fraction or portion of the ZnO-containing TCO layer is deposited on the buffer layer, wherein the resistance and the absorption should be as low as possible. In the second step (step 506 in FIG. 5), another fraction or portion of the ZnO-containing TCO layer is deposited, wherein desirable haze properties after etching are achieved. For example, high deposition temperatures as described above can lead to films with a low resistance but low haze as well. Yet, a relatively low deposition temperature as described above can lead to a higher film resistance but also to a higher or specific haze as desired. Therefore, as one example, the first ZnO fraction can be sputtered at a higher temperature followed by a film fraction sputtered at lower temperature. By combining both steps, the entire ZnO-containing TCO film stack can reveal a low resistance from the first fraction and a high haze after etching from the second fraction.

FIG. 8 illustrates an apparatus 800 for depositing a TCO layer according to embodiments described herein. The apparatus 800 includes several chambers 830 or respective compartments. A transport system with, for example, rollers 832 for transporting a substrate 802 through the system 800 is provided. Typically the chambers have openings 801 for introducing the substrate 802 into the chamber and transferring the substrate into a subsequent chamber or out of the chamber. According to typical embodiments, the openings 801 can be sealed with valves during operation of the system 800.

As shown in FIG. 8, heating systems with upper heating plates 850 and lower heating plates 852 can be provided in heating chambers 830a of the chambers 830. Particularly for sputtering the first ZnO-containing layer at higher temperatures, the heating chamber can be provided directly before the sputtering process. As a further option, a second heating chamber 830a (middle chamber in FIG. 8) can be provided for increasing the temperature during deposition of the first ZnO-containing layer in a first sputter chamber and a second sputter chamber.

According to typical embodiments, which can be combined with other embodiments described herein, the system 800 can be provided as an inline substrate processing system. As shown in FIG. 8, a substrate is thereby moved (from left to right in FIG. 8) into a first heating chamber, thereafter in a first sputter chamber for sputtering a first portion of the TCO layer, and thereafter in a second heating chamber for increasing the temperature before continuing the sputter process in a further sputter chamber for the first portion of the TCO layer. Thereafter the substrate is moved in a sputter chamber (right chamber in FIG. 8) for depositing the second portion of the TCO layer.

The sputter chambers include sputtering cathodes 814, such as rotatable sputtering cathodes, for sputtering the TCO layer, such as a zinc oxide layer, on the substrate 802. Thereby, a TCO layer with two portions, which can be textured in the subsequent processing step, such as a wet etching step, is deposited over the substrate.

As shown exemplarily for one cathode in Fig. 8, the TCO sputtering process is a DC sputtering process, wherein a power supply 822 provides a DC voltage between the cathodes 814 and, for example, the chamber wall 831. According to alternative embodiments the DC voltage might also be provided between the cathodes and separate anodes. According to yet further alternative or additional modifications, pulses might be added to the DC voltage, for example by a second power supply.

It is to be understood that the system 800 is for exemplary purposes. For example, according to alternative or additional modifications thereof, the second heating chamber 830a might be avoided and/or the first portion and the second portion of the TCO layer might be deposited in the same chamber, whereby the deposition parameters are varied by a controller. According to yet further alternative or additional modifications, the DC sputtering voltage might be provided between the cathodes and one or more anodes different from the chamber housing, wherein the anodes are provided in the sputter chambers.

In light of the above, a plurality of embodiments has been described. According to one embodiment, a layer stack for a thin film solar cell is provided. The layer stack includes a transparent substrate and a transparent conductive oxide layer deposited over the substrate, wherein the transparent conductive oxide layer includes a first sputtered ZnO-containing layer, which is sputtered with a sputtering method selected from the group consisting of: DC- sputtering, MF-sputtering, pulsed-sputtering, and combinations thereof; and a second sputtered ZnO-containing layer, which is sputtered with a sputtering method selected from the group consisting of: DC-sputtering, MF-sputtering, pulsed-sputtering, and combinations thereof, and which is deposited over the first DC-sputtered ZnO-containing layer and having at least one layer property different from the first ZnO layer. Thereby, the transparent conductive oxide layer is a textured layer. According to yet further embodiments, which can be combined with other embodiments described herein, the first DC-sputtered ZnO-containing layer can have a lower electrical resistance than the second DC-sputtered ZnO-containing layer; the first DC-sputtered ZnO-containing layer can have a lower optical absorption at a wavelength in the visible wavelength range and the near infrared wavelength range, particularly in a wavelength range of 300 nm to 1300 nm, than the second DC-sputtered ZnO-containing layer; and/or the textured transparent conductive oxide layer can be selected from the group consisting of: an etched transparent conductive oxide layer; a doped transparent conductive oxide layer and combinations thereof. According to yet further alternative or additional modifications, the layer stack can further include a buffer layer between the substrate and the transparent first DC-sputtered ZnO-containing layer, particularly with a layer thickness of 20 to 150 nm; the first DC-sputtered ZnO-containing layer can have a thickness of 300 to 800 nm and/or the second DC-sputtered ZnO-containing layer can have a thickness after texturing of 0 nm to 200 nm; and/or the substrate can have an area of 1 m² or more, typically of 5 m² or more.

According to another embodiment, a method of manufacturing a TCO layer of a thin film solar cell over a transparent substrate is provided. The method includes sputtering a first ZnO-containing layer with a sputtering method selected from the group consisting of: DC- sputtering, MF-sputtering, pulsed-sputtering, and combinations thereof, over the substrate with a first set of deposition parameters, sputtering a second ZnO-containing layer with a sputtering method selected from the group consisting of: DC- sputtering, MF-sputtering, pulsed-sputtering, and combinations thereof, over the first ZnO-containing layer with a second set of deposition parameters, , wherein at least one of the deposition parameters of the second set of deposition parameters is different from the corresponding parameter of the first set of deposition parameters; and texturing the second ZnO-containing layer. According to yet further embodiments, which can be combined with other embodiments described herein, the first and second set of deposition parameters can have a deposition parameter selected from the group comprising of: a deposition temperature, a gas flow, a deposition pressure, a deposition rate, a target to substrate distance, a predetermined shielding, a predetermined magnet arrangement, a target composition of a sputter target for depositing, a doping concentration provided during deposition, a doping material type provided during deposition, and combinations thereof; the first ZnO-containing layer can be deposited at a higher temperature than the second ZnO-containing layer, particularly wherein the first ZnO-containing layer is deposited at a temperature of 250 °C to 400 °C and the second ZnO-containing layer is deposited at a temperature of 100 °C to 350 °C; and the method can further includes at least one step selected from depositing a buffer layer between the substrate and the first ZnO-containing layer, and doping at least one of the first ZnO-containing layer and the second ZnO-containing layer. According to yet further additional or alternative modifications, at least one of the first and the second ZnO-containing layer can be deposited with a deposition rate adapted to deposited an 800 nm thick layer within 10 min or less; at least one of the first ZnO-containing layer and the second ZnO-containing layer can be sputtered with a rotatable cathode, particularly with a rotatable cathode having a length of 1 m or more; and/or the texturing can include etching the second ZnO-containing layer, particularly etching the second ZnO-containing layer with diluted acid.

Aside from the better light scattering properties after etching, the improved ZnO layers can also lead to a higher conductivity and reduced absorption since the overall film quality is improved. Further, it is expected to obtain a significantly higher solar module current and, therefore, higher efficiencies with respect to the standard approach without a two-layer or two sub-layer TCO deposition process.

While the foregoing is directed to embodiments of the present invention, other and further embodiments of the invention may be devised without departing from the basic scope thereof, and the scope thereof is determined by the claims that follow.

## Claims

1. A layer stack for a thin film solar cell, comprising:
a transparent substrate; and
a transparent conductive oxide layer deposited over the substrate, the transparent conductive oxide layer comprising:
a first sputtered ZnO-containing layer, which is sputtered with a sputtering method selected from the group consisting of: DC- sputtering, MF-sputtering, pulsed-sputtering, and combinations thereof; and
a second sputtered ZnO-containing layer, which is sputtered with a sputtering method selected from the group consisting of: DC- sputtering, MF-sputtering, pulsed-sputtering, and combinations thereof, and which is deposited over the first DC-sputtered ZnO-containing layer and having at least one layer property different from the first ZnO layer;
and wherein the transparent conductive oxide layer is a textured layer.

2. The layer stack according to claim 1, wherein the first sputtered ZnO-containing layer has a lower electrical resistance than the second sputtered ZnO-containing layer.

3. The layer stack according to any of claims 1 or 2, wherein the first sputtered ZnO-containing layer has a lower optical absorption at a wavelength in the visible wavelength range and the near infrared wavelength range, particularly in a wavelength range of 300 nm to 1300 nm, than the second sputtered ZnO-containing layer.

4. The layer stack according to any of claims 1 to 3, wherein the textured transparent conductive oxide layer is selected from the group consisting of: an etched transparent conductive oxide layer; a doped transparent conductive oxide layer and combinations thereof.

5. The layer stack according to any of claims 1 to 4, and further comprising:
a buffer layer between the substrate and the transparent first sputtered ZnO-containing layer, particularly with a layer thickness of 20 to 150 nm.

6. The layer stack according to any of claims 1 to 5, wherein the first sputtered ZnO-containing layer has a different doping than the second sputtered ZnO-containing layer.

7. The layer stack according to any of claims 1 to 6, wherein the first sputtered ZnO-containing layer has a thickness of 300 to 800 nm and/or the second sputtered ZnO-containing layer has a thickness after texturing of 0 nm to 200 nm.

8. The layer stack according to any of claims 1 to 7, wherein the substrate has an area of 1 m² or more, typically of 5 m² or more.

9. A method of manufacturing a TCO layer of a thin film solar cell over a transparent substrate, the method comprising:
sputtering a first ZnO-containing layer with a sputtering method selected from the group consisting of: DC- sputtering, MF-sputtering, pulsed-sputtering, and combinations thereof, over the substrate with a first set of deposition parameters, sputtering a second ZnO-containing layer with a sputtering method selected from the group consisting of: DC-sputtering, MF-sputtering, pulsed-sputtering, and combinations thereof, over the first ZnO-containing layer with a second set of deposition parameters, wherein at least one of the deposition parameters of the second set of deposition parameters is different from the corresponding parameter of the first set of deposition parameters; and
texturing the second ZnO-containing layer.

10. The method according to claim 9, wherein the first and second set of deposition parameters has a deposition parameter selected from the group consisting of: a deposition temperature, a gas flow, a deposition pressure, a deposition rate, a target to substrate distance, a predetermined shielding, a predetermined magnet arrangement, a target composition of a sputter target for depositing, a doping concentration provided during deposition, a doping material type provided during deposition, and combinations thereof.

11. The method according to any of claims 9 to 10, wherein the first ZnO-containing layer is deposited at a higher temperature than the second ZnO-containing layer, particularly wherein the first ZnO-containing layer is deposited at a temperature of 250 °C to 400 °C and the second ZnO-containing layer is deposited at a temperature of 100 °C to 350 °C.

12. The method according to any of claims 9 or 11, further comprising:
depositing a buffer layer between the substrate and the first ZnO-containing layer;
and/or
doping at least one of the first ZnO-containing layer and the second ZnO-containing layer.

13. The method according to any of claims 9 to 12, wherein at least one of the first and the second ZnO-containing layer is deposited with a deposition rate adapted to deposited an 800 nm thick layer within 10 min or less.

14. The method according to any of claims 9 to 13, wherein at least one of the first ZnO-containing layer and the second ZnO-containing layer is sputtered with a rotatable cathode, particularly with a rotatable cathode having a length of 1.1 m or more.

15. The method according to any of claims 9 to 14, wherein the texturing comprises:
etching the second ZnO-containing layer, particularly etching the second ZnO-containing layer with diluted acid.
